Europäisches Patentamt

European Patent Office

Office européen des brevets

(11) Publication number : **0 665 592 A1**

(12) # EUROPEAN PATENT APPLICATION

(21) Application number : 95300600.4

(22) Date of filing : 31.01.95

(51) Int. Cl.$^6$ : **H01L 23/495**

(30) Priority : **31.01.94 JP 27367/94**

(43) Date of publication of application :
**02.08.95 Bulletin 95/31**

(84) Designated Contracting States :
**DE FR GB NL**

(71) Applicant : **TEXAS INSTRUMENTS
INCORPORATED
13500 North Central Expressway
Dallas Texas 75265 (US)**

(72) Inventor : **Amagai, Masazumi
5-2, Higashisoen
Beppu-shi, Oita-ken 874 (JP)**
Inventor : **Ohsumi, Masaki
2-26-2, Kasuga
Tsukuba-shi, Ibaraki-ken 305 (JP)**

(74) Representative : **Blanco White, Henry Nicholas
et al
ABEL & IMRAY
Northumberland House
303-306 High Holborn
London WC1V 7LH (GB)**

(54) Semiconductor device and method of manufacturing the same.

(57) A semiconductor package has a first protective passivation film (13) applied to a semiconductor chip substrate (12), a second protective film (54) applied to the first protective film (13), and a lead frame (44,45) attached to the second protective film (54) and electrically connected to a circuit formed in the semiconductor chip (12). The main portion of the lead frame is attached to the second protective film (54) via a thermoplastic resin layer portion (54b) of the second protective film (54).

Figure 1

EP 0 665 592 A1

This invention concerns a package for a semiconductor device, in particular, a package having a LOC (Lead On Chip) structure, and its manufacturing method.

BACKGROUND OF THE INVENTION

A LOC structure with a lead frame carried on the circuit forming surface of the IC chip has been used as a package with an IC chip sealed in it.

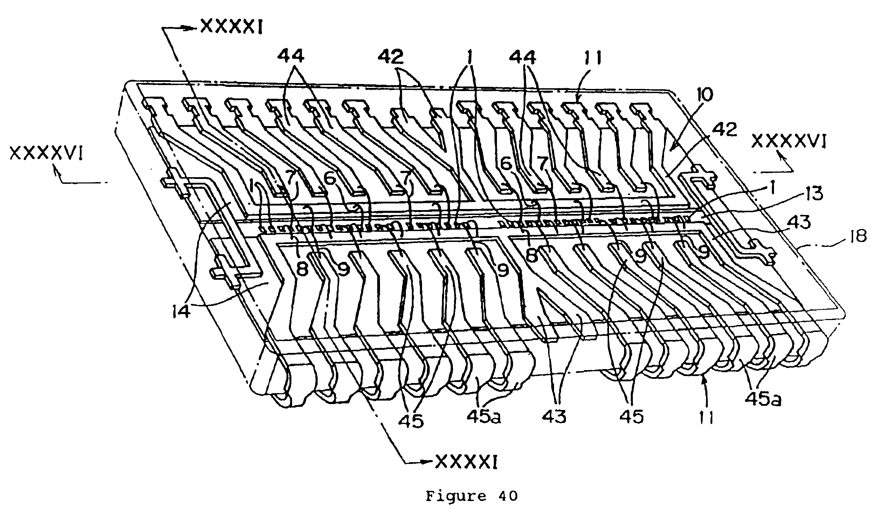

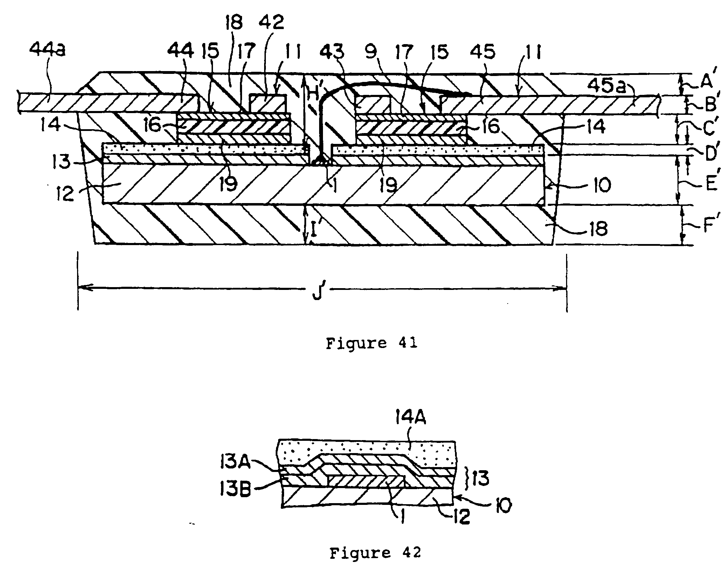

Figs. 40 and 41 illustrate a DRAM (dynamic RAM) package with a conventional LOC structure. In this case, multiple bonding pads 1 are arranged in a single straight line (pad column) at the central portion of a semiconductor IC chip 10. On the two sides of the pad column, power source lines 42, 43, known as bus bars, and multiple signal lines 44, 45 are arranged, respectively, forming a lead frame 11 for the LOC. This lead frame can be made of an iron-nickel alloy, copper alloy, or copper.

The bus bars 42, 43 can be connected to power sources $V_{ss}$ and $V_{cc}$. On the other hand, signal lines 44, 45 are used for the various signals, such as addresses $A_0$-$A_{10}$, CAS, RAS, etc.

Connection of the bonding pads 1 to the various lines is performed by means of a first set of bonding wires 6, 7 on one side of the bonding pad column, and by means of a second set of bonding wires 8, 9 on the other side. In this case, wires 7, 9 connecting signal lines 44, 45 to corresponding to pads 1 straddle bus bars 42, 43. The overall body is sealed off by epoxy resin 18 or some other molding resin (represented by broken lines in Fig. 40), with the outer lead portions of the various wires exposed outside molding resin 18.

In the type of IC chip package shown in Fig. 41, due to the LOC construction the lead frame 11 is attached on the IC chip (more specifically, on its circuit-forming surface), as will now be explained in detail with reference to Fig. 41.

First, as far as IC chip 10 is concerned, for example, on one principal surface of a silicon substrate 12, a passivation film (protective film) 13 of $SiO_2$ or the like is provided. The bonding pads 1, which are connected to the internal circuit of IC chip 10, are formed on the silicon substrate at openings provided in the passivation film. Except for the region of the bonding pads, the entire surface is coated with a heat-settable polyimide-type protective film 14.

The molding resin 18 usually contains a filler, such as $SiO_2$ added for reducing its thermal expansion coefficient. However, such a filler may contain an $\alpha$ particle-emitting radioactive element, such as uranium or thorium. When $\alpha$ particles emitted from the radioactive element in the filler irradiate the IC chip 10, circuit operating errors called "soft errors" may occur. The polyimide-type protective film 14 is particularly arranged to block invasion of the $\alpha$ particles, to prevent soft errors.

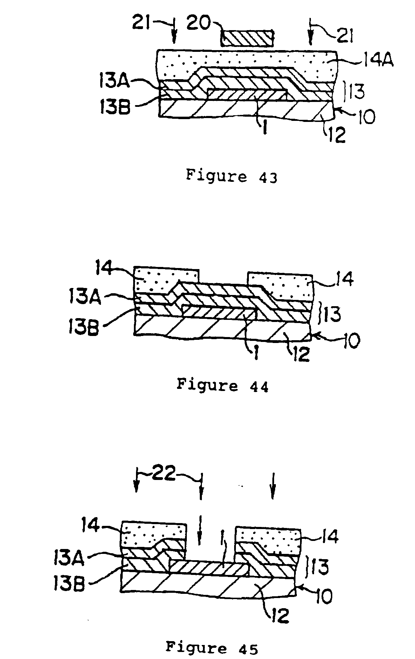

Figs. 42-45 are schematic diagrams illustrating the process of forming a polyimide resin protective film 14 on a laminate passivation film 13 made of a $Si_3N_4$ film 13A and $SiO_2$ film 13B. First of all, a noncured heat-settable polyimide-type resin 14Ais coated on the entire surface (Fig. 42), followed by exposure to UV irradiation 21 using an exposure mask 20 (Fig. 43). The unexposed portion of the resin is removed by etching, and curing is performed to form a cured polyimide resin protective film 14 (Fig. 44). A selected portion of passivation film 14 above pads 1 is then removed by means of a $CF_4/O_2$ plasma 22, (Fig. 45).

Then lead frame 11 is then bonded onto polyimide resin protective film 14 by means of a double-sided adhesive insulating tape 15 (for simplification the insulating tape 15 is not shown in Fig. 40). As shown in Fig. 41, this insulating tape 15 is prepared by coating adhesives 17, 19 respectively on the two sides of an insulating film substrate 16. Adhesive 17 on one side is for bonding lead frame 11 to substrate 16 under heat and pressure. Adhesive 19 on the other side is for bonding substrate 16 under heat and pressure to the polyimide resin protective film 14 of IC chip 10. In this way, lead frame 11 is mounted by pressure and bonding (mount-pressing) on IC chip 10 by means of insulating tape 15.

In the aforementioned package, lead frame 11 is attached to IC chip 10 by insulating tape 15. Consequently, as the thickness of the tape's insulating film substrate 16 is, say, 50 $\mu$m, and the thicknesses of adhesive layers 17 and 19 on the two sides are, say, 12.5 $\mu$m, respectively, the total thickness of insulating tape 15 becomes 75 $\mu$m (or in the range of 75-175 $\mu$m depending on the conditions), leading to the following disadvantages (1)-(4).

(1) Breakage of metal wiring may take place after mount-pressing and in the temperature cycles.

During the aforementioned process of the mount-pressing of lead frame 11, a stress represented by the following formula occurs.

$$\text{Stress} = \int_{-65}^{T_m} (\alpha_2 - \alpha_1) E_2 \, hWdT \qquad (1)$$

2

where,:

$T_m$: temperature during the mounting operation (°C)

-65: lowest temperature in the temperature cycle (°C)

$\alpha_2$: thermal expansion coefficient of insulating tape containing adhesive

$\alpha_1$: thermal expansion coefficient of silicon substrate of IC chip

h: thickness of insulating tape containing adhesive ($\mu$m)

W: width of insulating tape containing adhesive ($\mu$m)

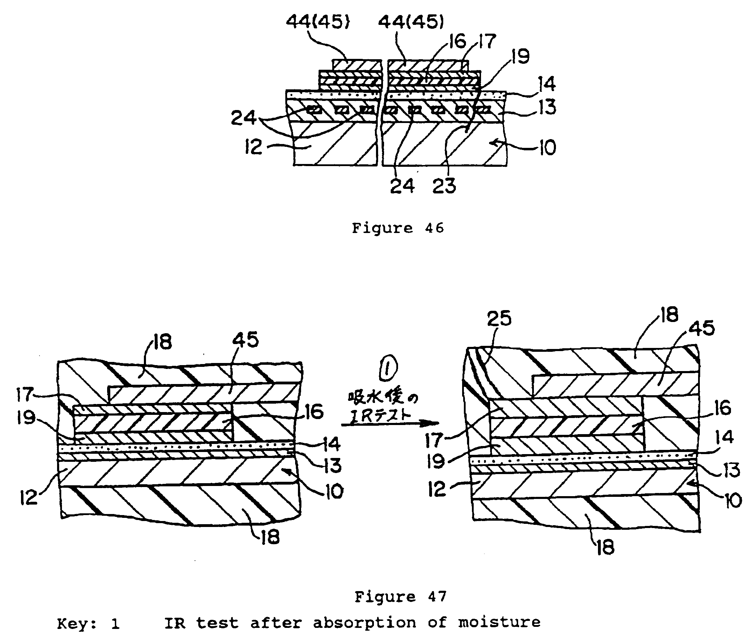

As can be seen from the aforementioned stress formula, when the thickness h of the insulating tape containing adhesive and its thermal expansion coefficient $\alpha_2$ are large, the stress is prone to become high during the mount-pressing operation for the lead frame. When said lead frame 11 is mount-pressed, as insulating tape 15 is used, due to the thickness and the thermal expansion coefficient of this insulating tape 15, as shown in Fig. 46, cracks 23 are generated inside IC chip 10, in particular, from the end portion of insulating tape 15, and breakage of metal wiring 24 may take place.

(2) Generation of package cracks due to expansion of the insulating tape generated during IR reflow.

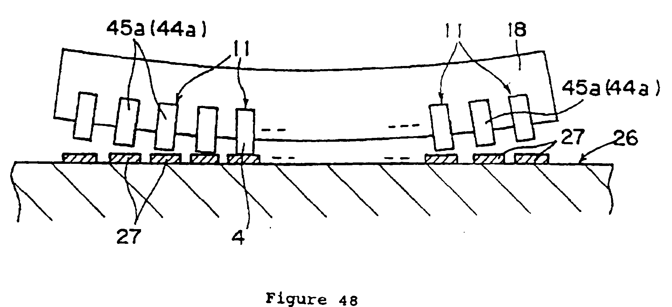

As shown in Fig. 48, when the completed IC package is attached to a printed wiring board 26, as a scheme for soldering outer lead portion 45a or 44a on circuit pattern 27, IR reflow method is carried out by bonding with heating performed using infrared [radiation] (IR). When IR reflow is performed, the IC package is heated to a peak temperature of about 245°C.

Since the total thickness of the insulating tape 15 (75 $\mu$m) is large, and the moisture absorption of the tape itself is as high as in the range of 2-2.5% (85°C, 85%RH), when the package is placed in the atmosphere for a long time, moisture is absorbed. As shown in Fig. 47, swelling of adhesive layers 17 and 19 may easily occur. As a result, during the IR reflow process, cracks 25 may be developed in sealing resin 18, and package cracks may occur. Among the 120 samples, package cracks occurred in 16 of them.

(3) Generation of package warpage.

The specific sizes of the various portions represented by A', B', C', D', E', F', H', I', and J' are listed in the following Table I. In this case, the data are listed for both a TSOP (Thin Small Outline Package) with a total thickness of about 1 mm (1000 $\mu$m) and a SOJ (Single Outline J-lead Package) with a total thickness of about 2.7 mm (2700 $\mu$m).

Table I

| (See Fig. 41) | 1mm T S O P | | 2.7mm S O J | |
|---|---|---|---|---|
| A' | 0.195mm | (195$\mu$m) | 0.810mm | (810$\mu$m) |
| B' | 0.125mm | (125$\mu$m) | 0.200mm | (200$\mu$m) |
| C' | 0.075mm | (75$\mu$m) | 0.075mm | (75$\mu$m) |
| D' | 0.020mm | (20$\mu$m) | 0.010mm | (10$\mu$m) |
| E' | 0.280mm | (280$\mu$m) | 0.280mm | (280$\mu$m) |
| F' | 0.325mm | (325$\mu$m) | 1.335mm | (1335$\mu$m) |
| H' | 0.405mm | (405$\mu$m) | 1.905mm | (1905$\mu$m) |
| I' | 0.325mm | (325$\mu$m) | 1.335mm | (1335$\mu$m) |
| J' | 15.240mm | (15240$\mu$m) | 15.240mm | (15240$\mu$m) |

Since the insulating tape 15 has a large thickness (C'= 75 $\mu$m), it is difficult to realize a structural balance in the package. In particular, for the TSOP package with a thickness of 1 mm, the package warpage caused by the large thickness of tape (75 $\mu$m) may easily occur.

For the conventional 1-mm TSOP package, it is difficult to make the thickness A' of the resin on the lead frame less than 195 $\mu$m. This is due to the wire bonder ability and due to the fact that the wire loop is not outside the package. Consequently, when the thickness of the IC chip, E', is 280 $\mu$m, the thickness of the resin on the chip H'= 405 $\mu$m, and the thickness of the resin below the chip I'= 325 $\mu$m. The unbalanced thickness relationship is a natural result of the fact that the insulating tape thickness is C'= 75 $\mu$m, and this leads to problem related to the problem of package warpage.

As shown in an exaggerated manner in Fig. 48, due to occurrence of the package warpage, the package warps by 30-60 $\mu$m. In particular, the outer portion 45a or 44a on the two end portions float up with respect to circuit pattern 27 on printed wiring substrate 26, and no connection is made.

(4) Cost Increase.

For insulating tape 15 bonded with said lead frame 11, the price is as high as several tens of yen (tens of cents) for each unit. Consequently, the cost of the package rises, and there is thus a limit on the cost-cutting efforts.

## SUMMARY OF THE INVENTION

This invention solves the aforementioned problems of the conventional methods by providing a type of semiconductor device with a package structure, and its manufacturing method, preventing chip cracks and breakage of wiring after mount-pressing the lead frame and during the temperature cycles, suppressing package cracks and package warpage during the IR reflow process, and manufacturable at a low cost.

In a semiconductor device embodiment according to the invention, a second protective film is arranged on the protective film of the semiconductor chip, a lead frame is attached to the second protective film, and the lead frame is electrically connected to the circuit of the aforementioned semiconductor chip. The main portion of the aforementioned lead frame is attached to the second protective film via a thermoplastic resin which acts at least as a portion of the aforementioned second protective film.

In an embodiment of the invention, the second protective film consists of a laminate having a lower layer made of a heat-settable polyimide-type resin and an upper layer made of thermoplastic polyimide-type resin. For the aforementioned laminate, in the region where the lead frame is bonded, the thermoplastic polyimide-type resin layer and the heat-settable polyimide-type resin layer are formed in almost the same pattern. For example, the thickness of the aforementioned thermoplastic polyimide-type resin layer is 15-35 $\mu$m, and the thickness of the aforementioned heat-settable polyimide-type resin layer is 10-30 $\mu$m; in the nonbonding region of the aforementioned lead frame, the thickness of the aforementioned heat-settable polyimide-type resin layer is 5-15 $\mu$m.

It is also possible that in the aforementioned laminate, a thermoplastic polyimide-type resin layer is also formed on the heat-settable polyimide-type resin layer in the nonbonding region, the thickness of the aforementioned thermoplastic polyimide-type resin layer is 15-35 $\mu$m, and the thickness of the aforementioned heat-settable polyimide-type resin layer is 10-30 $\mu$m.

In both cases, the total thickness of the laminate should be 35-65 $\mu$m, at least in the bonding region of the lead frame.

In another semiconductor device of this invention, the aforementioned second protective film may also consist of the thermoplastic polyimide-type resin layer alone. In this case, the thickness of the thermoplastic polyimide-type resin layer may be 30-50 $\mu$m. Also, it is preferred that the thermoplastic polyimide-type resin layer be also arranged on the nonbonding region of the lead frame.

In a semiconductor device of this invention, in the lead frame bonding region, the end portion of the thermoplastic polyimide-type resin layer may protrude by 0.1-0.15 mm from the end portion of the aforementioned lead frame (in particular, the width of the thermoplastic polyimide-type resin layer may be larger than the width of the aforementioned lead frame by 0.1-0.15 mm on each side).

On the side of the semiconductor chip's bonding pad, the gap between the end of the cell portion of the aforementioned semiconductor chip and the end of the thermoplastic polyimide-type resin layer may be 100-500 $\mu$m.

Also, in the region of the bonding pad, there may be the heat-settable polyimide-type resin layer and/or thermoplastic polyimide-type resin layer.

In practice, for the semiconductor device of this invention, the bonding pad and the lead frame may be wire-bonded, and the overall assembly may be sealed by a molding resin. Also, the lead frame may have a lead frame portion for the signal lines and a lead frame portion for the power source lines.

When a semiconductor device of this invention is manufactured, a preferred method has the following steps: at least a thermoplastic resin layer is coated on the protective film of the semiconductor chip; after patterning and curing of the coated resin layer, the lead frame is bonded to the aforementioned thermoplastic resin layer.

In this case, in practice, after bonding of the lead frame, the bonding pad of the semiconductor chip and the aforementioned lead frame are wire-bonded, followed by sealing the overall assembly by a molding resin.

These and other features of the invention will be explained with more detailed reference to the drawings.

## BRIEF DESCRIPTION OF DRAWINGS

Fig. 1 is a cross-sectional view of an IC package with a LOC structure according to a first embodiment of this invention;

Fig. 2 is an enlarged cross-sectional view of the principal portion of the package of Fig. 1 (along line II-II in Fig. 4);

Fig. 3 is an enlarged cross-sectional view of the main portion of the package of Fig. 1 (along line III-III in Fig. 4);

Fig. 4 is a schematic plane view of the main portion of the package of Fig. 1;

Fig. 5 is an enlarged diagram illustrating a portion of the aforementioned plane view of Fig. 4;

Fig. 6 is a cross-sectional view of a portion corresponding to line VI-VI in Fig. 5 illustrating generation of the package voids;

Fig. 7 is an enlarged oblique view of the principal portion of the package of Fig. 1;

Fig. 8 is a cross-sectional view illustrating a stage in the manufacturing method of the package of Fig. 1;

Fig. 9 is a cross-sectional view illustrating another stage of the manufacturing method of the package of Fig. 1;

Fig. 10 is a cross-sectional view illustrating another stage of the manufacturing method of the package of Fig. 1;

Fig. 11 is a cross-sectional view illustrating another stage of the manufacturing method of the package of Fig. 1;

Fig. 12 is an enlarged oblique view of the principal portion of the package of Fig. 1;

Fig. 13 is a cross-sectional view illustrating a stage in the manufacturing method of the package of Fig. 1;

Fig. 14 is a cross-sectional view illustrating another stage of the manufacturing method of the package of Fig. 1;

Fig. 15 is a cross-sectional view illustrating another stage of the manufacturing method of the package of Fig. 1;

Fig. 16 is a cross-sectional view illustrating another stage of the manufacturing method of the package of Fig. 1;

Fig. 17 is a schematic plane view of the principal portion of an IC package having a LOC structure according to a second embodiment of the invention;

Fig. 18 is an enlarged cross-sectional view illustrating the principal portion of the package of Fig. 17;

Fig. 19 is an enlarged oblique view illustrating the principal portion of the package of Fig. 17;

Fig. 20 is a cross-sectional view illustrating a stage of the manufacturing method of the package of Fig. 17;

Fig. 21 is a cross-sectional view illustrating another stage of the manufacturing method of the package of Fig. 17;

Fig. 22 is a cross-sectional view illustrating another stage of the manufacturing method of the package of Fig. 17;

Fig. 23 is a cross-sectional view illustrating another stage of the manufacturing method of the package of Fig. 17;

Fig. 24 is a cross-sectional view illustrating another stage of the manufacturing method of the package of Fig. 17;

Fig. 25 is a cross-sectional view illustrating another stage of the manufacturing method of the package of Fig. 17;

Fig. 26 is a cross-sectional view illustrating yet another stage of the manufacturing method of the package of Fig. 17;

Fig. 27 is a schematic plane view of the principal portion of an IC package having a LOC structure according to a third embodiment of this invention;

Fig. 28 is an enlarged oblique view of the package of Fig. 27;

Fig. 29 is a cross-sectional view illustrating a stage in the manufacturing method of the package of Fig. 27;

Fig. 30 is a cross-sectional view illustrating another stage of the manufacturing method of the package of Fig. 27;

Fig. 31 is a cross-sectional view illustrating another stage of the manufacturing method of the package of Fig. 27;

Fig. 32 is a cross-sectional view illustrating another stage of the manufacturing method of the package of Fig. 27;

Fig. 33 is a cross-sectional view illustrating another stage of the manufacturing method of the package of Fig. 27;

Fig. 34 is a cross-sectional view illustrating yet another stage of the manufacturing method of the package of Fig. 27;

Fig. 35 is a graph illustrating the soft error rate (defective rate) caused by $\alpha$ particles and an enlarged cross-sectional view illustrating the principal portion of the package of Fig. 27;

Fig. 36 is a graph illustrating the variation in the parasitic capacitance;

Fig. 37 is a cross-sectional view of a sample for illustrating the status of the peel test;

Fig. 38 is a plane view of the lead frame of an IC package having a LOC structure according to a fourth embodiment of the invention;

Fig. 39 is a cross-sectional view of an IC package according to a fifth embodiment of this invention;

Fig. 40 is an oblique view of the principal portion of a package having a conventional LOC structure;

Fig. 41 is a cross-sectional view along line XXXI-XXXI in Fig. 40;

Fig. 42 is a cross-sectional view illustrating a stage in the manufacturing method of the package of Fig. 40;

Fig. 43 is a cross-sectional view illustrating another stage in the manufacturing method of the package of Fig. 40;

Fig. 44 is a cross-sectional view illustrating another stage in the manufacturing method of the package of Fig. 40;

Fig. 45 is a cross-sectional view illustrating yet another stage in the manufacturing method of the package of Fig. 40;

Fig. 46 is a cross-sectional view along line XXXVI-XXXVI in Fig. 40 of the principal portion of the package of Fig. 40;

Fig. 47 is an enlarged cross-sectional view of the principal portion of the package of Fig. 40 in an IR reflow test;

Fig. 48 is a schematic side view illustrating the warping of the package of Fig. 40 caused by thick insulating tape.

## DETAILED DESCRIPTION OF PREFERRED EMBODIMENTS

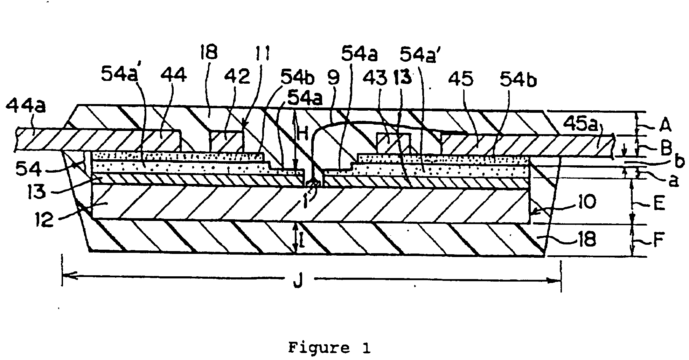

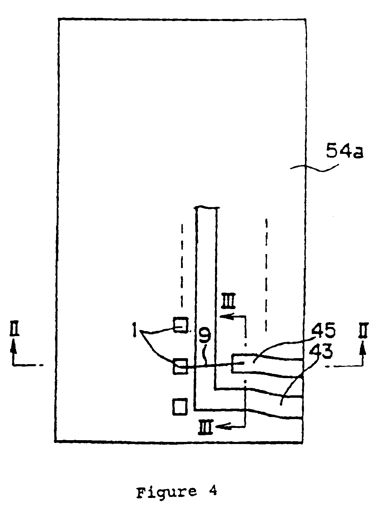

Figs. 1-16 illustrate Embodiment 1 of this invention for the DRAM package, in which the parts corresponding to those in the conventional method of Figs. 40-48 are represented by the same symbols.

First, consider the configuration of the package with LOC structure in this embodiment. The package has the following features in structure: a heat-settable polyimide-type resin layer 54a and a thermoplastic polyimide-type resin layer 54b are laminated on passivation film 13 of IC chip 10 to form a laminate 54. Among these two polyimide resin layers 54a and 54b, resin layer 54a is provided to prevent the soft error caused by $\alpha$ particles emitted by the filler of sealing resin 18 just as was polyimide resin protective film 14 in Fig. 41. Also, the thermoplastic property of resin layer 54b is exploited to enable thermal pressing and bonding (mount-pressing) of bus bars 42, 43 and signal lines 44, 45 of lead frame 11 on this layer.

That is, for said laminate 54 and resin layer 54a, the polyimide resin layer arranged on IC chip acts as the second protective film just as said polyimide resin protective film 14. On the other hand, thermoplastic polyimide-type resin layer 54b, a portion of the protective film, is used as an adhesive with respect to lead frame 11, while the insulating tape 15 of Fig. 41 is not used. This is a prominent feature.

The heat-settable polyimide-type resin layer 54a is provided on almost the entire region except for bonding pad 1. In the press-bonding region of bus bars 42, 43 and signal lines 44, 45 of lead frame 11, with a nearly identical pattern, a laminate 54 is formed from heat-settable polyimide-type resin layer 54a and thermoplastic polyimide-type resin layer 54b, forming a relatively thick protrusion strip portion. In this protrusion strip portion, the heat-settable polyimide-type resin layer is represented by 54a' to be differentiated from same type of resin layer 54a in the other regions.

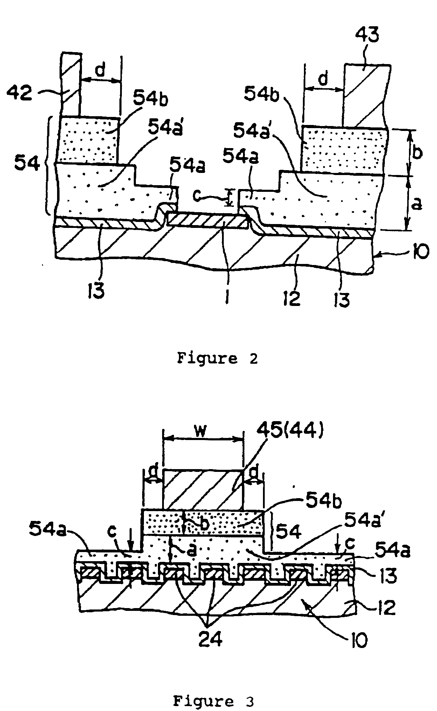

It is preferred that the thicknesses of the various polyimide resin layers be selected as follows (see Fig. 3).

thickness of heat-settable polyimide-type resin layer 54a' (a) = 10-30 $\mu$m

thickness of thermoplastic polyimide-type resin layer 54b (b) = 15-35 $\mu$m

thickness of heat-settable polyimide-type resin layer 54a (c) = 5-15 $\mu$m

Total thickness of heat-settable polyimide-type resin layer 54a' and thermoplastic polyimide-type resin layer 54b (a + b) = 35-65 $\mu$m.

Width of lead frame (signal lines and bus bars) (w) = about 400 $\mu$m

Gap between the edge face of the lead frame and the edge face of thermoplastic polyimide-type resin layer 54b (d) = 100-150 $\mu$m

In the following, the reasons for making the aforementioned selection of the thicknesses of the various polyimide resin layers will be presented.

Thickness (b) of polyimide resin layer 54b:

When the inner lead portion of the lead frame is mounted on the upper surface of IC chip 10, in order to guarantee the wettability of polyimide resin 54b, thickness (b) has to be 15-35 $\mu$m.

Thickness (a) of polyimide resin layer 54a' and total thickness (a + b) of polyimide resin layers:

Since thickness (a) should be at least 10 $\mu$m, the total thickness (a + b) is 35-65 $\mu$m. This is for suppressing the electrostatic capacitance of the two layers of polyimide resin 54a' and 54b between lead frame 11 and metal layer 24, and for shielding the lead frame from $\alpha$ particles. The upper limit of the total thickness (a + b) is selected to prevent the package cracks caused by the polyimide resin with a high moisture absorption, and for facilitating handling of the package balance with respect to the 1-mm-thick TSOP or other thin package.

Thickness (c) of resin layer 54a:

In order to prevent damage of the circuit by $\alpha$ particles emitted from the filler in the sealing resin, this thickness should be at least 5 $\mu$m. On the other hand, in order to prevent warpage of the IC chip, this thickness should be less than 15 $\mu$m.

Gap (d) between the edge face of the lead frame and the edge face of resin layer 54b:

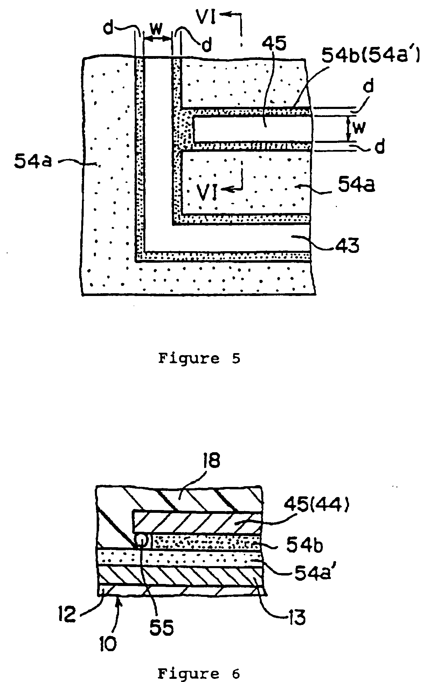

This gap (d) should be 100-150 $\mu$m. The area of polyimide resin layer 54b should be as small as possible with respect to the pattern in the inner lead portion. However, in consideration of the deviation in position during mounting operation of the lead frame, d should be 100-150 $\mu$m. As shown in Fig. 6, if d is too small, package voids 55 without sealing resin 18 may easily be formed. The reason for reducing the area of polyimide resin layer 54b is for preventing warpage of the IC chip and for preventing the package cracks caused by the polyimide resin with a high moisture absorption.

For the overall package, the sizes of the various portions denoted by A, B, b, a, E, F, H, I, and J shown in Fig. 1 can be set as listed in following Table II.

Table II

|  | 1 mm T S O P | | 2.7mm S O J | |
|---|---|---|---|---|
| A | 0.195mm | (195$\mu$m) | 0.810mm | (810$\mu$m) |
| B | 0.125mm | (125$\mu$m) | 0.200mm | (200$\mu$m) |
| b | 0.020mm | (20$\mu$m) | 0.020mm | (20$\mu$m) |
| a | 0.020mm | (20$\mu$m) | 0.020mm | (20$\mu$m) |
| (c) | (0.010mm | (10$\mu$m)) | (0.010mm | (10$\mu$m)) |
| E | 0.280mm | (280$\mu$m) | 0.280mm | (280$\mu$m) |
| F | 0.370mm | (370$\mu$m) | 1.380mm | (1380$\mu$m) |
| H | 0.360mm | (360$\mu$m) | 1.050mm | (1050$\mu$m) |
| I | 0.370mm | (370$\mu$m) | 1.380mm | (1380$\mu$m) |
| J | 15.240mm | (15240$\mu$m) | 15.240mm | (15240$\mu$m) |

In consideration of the ability of wire bonder and to ensure that the wire does not expose on the outer surface of the package sealing resin and its vicinity, it is necessary to form a layer of resin with thickness A of 195 $\mu$m on lead frame 11. Even when this factor is taken into consideration, the package in the application example of this invention, does not use the conventional double-sided adhesive-attached insulating tape for mount=pressing of lead frame 11, and the thermoplastic properties (adhesive property after heating) of thermoplastic polyimide-type resin layer 54b, which forms a portion of the second protective film, are used to directly press lead frame 11 on this resin layer; hence, it is possible to have thickness H of the resin layer on the IC chip in the range of 355-385 $\mu$m (say, 360 $\mu$m), and thickness I of the resin layer beneath IC chip in the range of 350-380 μm (say, 370 μm) (thickness of IC chip is 280 μm).

In other words, since no insulating tape is used, and the lead frame is directly bonded to the polyimide resin layer, it is possible to realize the following significant effects (1)-(4).

(1) It is possible to prevent metal wire breakage after mount-pressing and during the temperature cycles.

Since the insulating tape for mounting in the conventional scheme is as thick as 75-175 μm, the thermal stress is high. On the other hand, in the case of this embodiment, the thickness of the polyimide resin layer is as small as 35-65 μm. Consequently, it is possible to have the tensile stress lower by 30% than the conventional type.

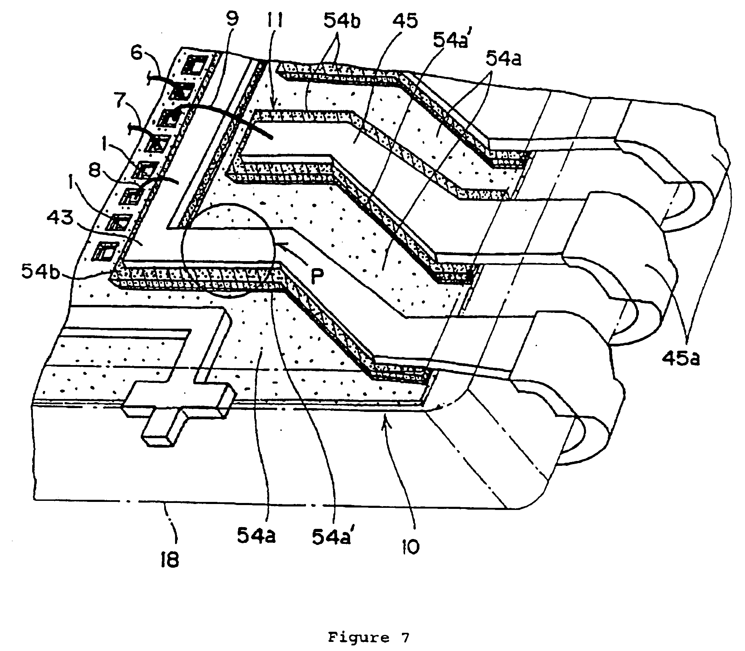

In particular, as shown in Fig. 7, in the interior of the package, the maximum stress is concentrated on the surface of the chip right below corner portion P of the bus bars. Consequently, the tensile stress displays an adverse influence on the characteristics of the device. During the temperature cycles of 150°C to -65°C, the tensile stress on the surface of the aforementioned chip was derived, and it was found that for the configuration shown in Fig. 1 in this embodiment, the tensile stress is 2.90 kg/mm$^2$. This is a decrease of about 30% than the tensile stress of 4.20 kg/mm$^2$ for the structure shown in Fig. 41.

(2) It is possible to prevent package cracks which are likely to take place during IR reflow.

As the volume of the adhesive layer (the polyimide resin layer) is reduced, the water absorption is decreased. Consequently, the frequency of the package cracks during IR reflow can be reduced significantly or can be prevented entirely. In this case, it was found that no package cracks took place for all of the 120 samples measured.

(3) It is possible to prevent package warpage.

In particular, in 1-mm TSOP, etc., the balance between the thickness of the upper resin layer and that of the lower resin layer with respect to the chip in the package can be realized easily by means of a balance between H and I. It is thus possible to suppress the warpage of the package to smaller than 20 μm or to completely eliminate the warpage.

(4) It is possible to cut the cost.

Compared with the cost of the conventional insulating tape (attached to lead frame), for the mounting structure in this embodiment, the cost of each unit can be cut to about 1/7 to 1/33 or lower.

In the following, examples will be presented for the package of the embodiment.

First of all, the structural materials used in this case are as follows.

Thermoplastic polyimide-type resin 54b

Tensile strength: 10 kg/mm$^2$ (room temperature)
Tensile modulus: 280 kg/mm$^2$ (room temperature)
Tensile elongation: 10% (room temperature)
Volumetric resistivity: 6.3 x 10$^{16}$ Ω-cm
Leak current: 1.61 x 10$^{-11}$ (A) (room temperature)
1.07 x 10$^{-11}$ (A) (PCT after 500 h)
(PCT (Pressure Cooker Test) is a stress-test method performed by setting the specimen for test at 121°C under a gauge pressure of 1 atm, and observing the variation in the characteristics after the test)
Pyrolysis temperature: 520°C
Thermal expansion coefficient: 4.3 x 10$^{-5}$ (1/°C) (30-100°C)
Glass transition: 240°C (in the range of 160-300°C for the sample evaluation)
Moisture absorption: 0.91% (22°C, 60% RH)

Heat-settable polyimide-type resins 54a, 54a':

Tensile strength: 15 kg/mm$^2$ (room temperature)
Tensile modulus: 300 kg/mm$^2$ (room temperature)
Tensile elongation: 30% (room temperature)
Volumetric resistivity: 10$^{16}$ Ω-cm
Pyrolysis temperature: 500°C
Thermal expansion coefficient: 4.0 x 10$^{-5}$ (1/°C) (30-100°C)
Moisture absorption: 0.80% (22°C, 60% RH)

Heat-settable molding resins 18:

Multifunctional epoxy resin

Tensile strength: 14.2 kg/mm$^2$ (room temperature)
Tensile modulus: 1580 kg/mm$^2$ (room temperature)
Glass transition point: 157°C
Thermal expansion coefficient: 0.9 x 10$^{-5}$ (1/°C) (below the glass transition point); 4.3 x 10$^{-5}$ (1/°C) (over the glass transition point)

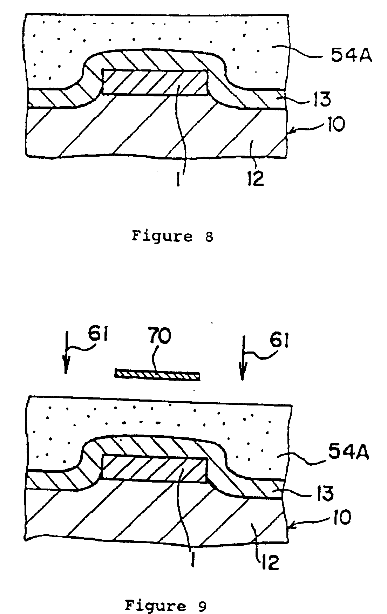

The principal process of the manufacturing method of the package in this embodiment is explained in the following. First of all, as shown in Fig. 8, a 20-μm-thick layer of heat-settable polyimide-type resin 54A [sic] was coated on a passivation film 13 with semiconductor circuit formed on it. Prebaking was then performed (100°C x 360 sec).

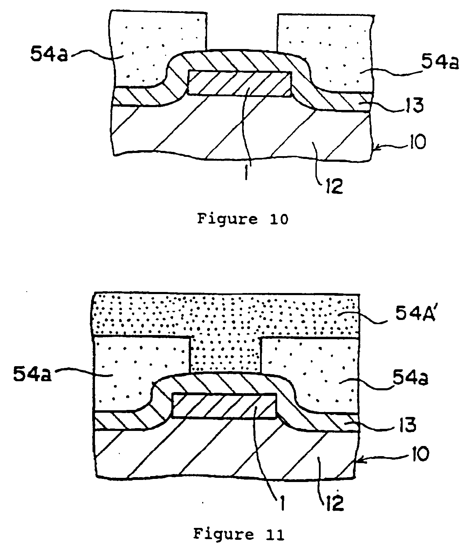

As shown in Fig. 9, overall exposure was performed by using UV light 61 with the aid of exposure mask 70 for 70 sec. As shown in Fig. 10, the portion of bonding pad 1 and the scribe lines (not shown in the figure) were then formed by etching, followed by heat setting of the polyimide resin at 390°C for 60 min, forming resin layer 54a.

As shown in Fig. 11, after the same type of polyimide resin 54A' at a thickness of 20 μm was spin-coated, prebaking was performed (100°C x 360 sec).

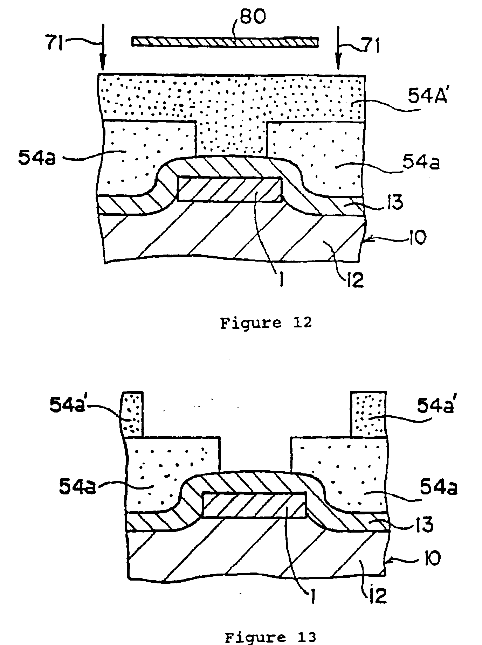

As shown in Fig. 12, after overall exposure was performed by UV light 71 with the aid of exposure mask 80 for 70 sec, as shown in Fig. 13, the scribe lines and bonding pad are etched appropriately to ensure the inner lead width (0.4 mm) + protruding width d (0.1 mm x 2 on the two sides). Heat setting (curing) was then performed at 390°C for 60 min.

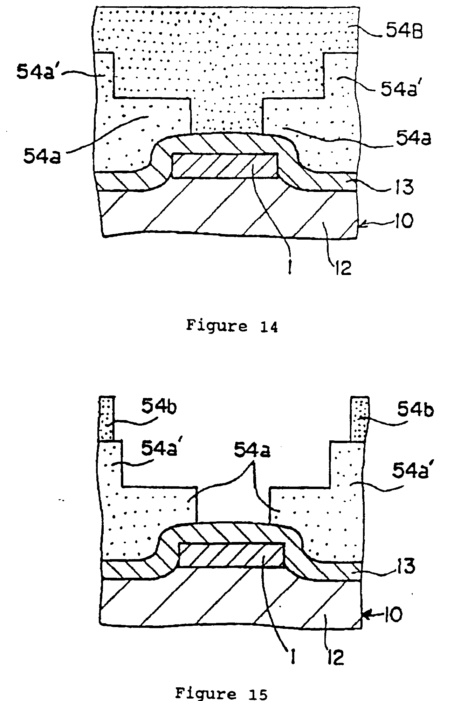

As shown in Fig. 14, thermoplastic polyimide-type resin 54B was applied, followed by prebaking at 125°C for 2 min on a hot plate.

As shown in Fig. 15, after coating of resist, UV exposure equipment was used to perform exposure at 250 mJ/cm, followed by development treatment (etching) of the scribe line and bonding pad portions using an alkaline development solution and performed in an appropriate manner to ensure the inner lead width (0.4 mm) + protrusion width (two-sided 0.1 mm x 2), forming resin layer 54b.

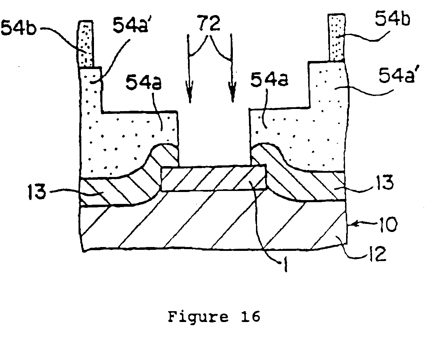

Then, after peeling of the resist, final curing was performed (250°C x 60 min). As shown in Fig. 16, by means of $CF_4$ + $O_2$ plasma 72, the passivation film on pad 1 was removed.

In addition, as shown in Fig. 2, after the inner lead (made of 42-alloy) was hot-pressed at 350°C x 4 kg, wire bonding was performed by means of wire (made of 99.99% gold), followed by injection molding of heat-settable molding resin and then heat setting (curing) at 175°C for 5 h. The obtained package is of the SOJ 34-pin type measuring 600 mil (width) x 875 mil (length) x 106 mil (height) (see Fig. 7).

For the package of this embodiment prepared in the aforementioned process, the following items of evaluation were performed.

Mount-heat-pressing of the lead frame:

The glass transition point of the thermoplastic polyimide-type resin is preferably of 300°C or lower. Since the pressing temperature of the mount is equal to the glass transition point + 100°C, good results can be obtained when the glass transition point is in the range of 160-300°C, with consideration given to wettability of the mount.

Wire bonding stage of operation:

The glass transition point of the thermoplastic polyimide-type resin is preferably of 200°C or higher. The reason is as follows: since the wire bonding temperature is 200°C, if the glass transition point is lower than 200°C for the polyimide resin, the wire bonding operation falls in the viscoelastic region, and defects in lead bonding may take place easily.

IR reflow test after setting at 85°C/85% RH:

If the glass transition point of the heat-settable polyimide-type resin is 230°C or lower, package cracks may easily occur. This is because, due to IR reflow (maximum 245°C), the temperature near the chip inside the package reaches about 230°C.

Thermal cycle test (-65°C to 150°C):

After 2000 cycles, the rate of trouble was 0/20 (no problem among 20 samples), that is, there were no problems.

(The thermal cycle test was performed as follows: the sample was heated from -65°C to 150°C for (over) 15 min, and then cooled from 150°C to -65°C for 15 min. This is taken as a cycle. The variation in the various properties after the cycles was observed).

Electrical degradation (electrical characteristics test):

4M DRAM was used in the test. With $V_{cc}$ = 5.65 V applied on it, current $I_{dd}$ was observed.

|  | Tape-attached LOC (conventional sample) | Sample of this invention |
|---|---|---|
| Mean value | 61.94mA | 62.35mA |
| Standard error | 1.35mA | 1.57mA |

4M DRAM was used in the test. With $V_{cc}$ = 4.35 V applied on it, $t_{RAC}$ (access time from RAS) was observed.

|  | Tape-attached LOC (conventional sample) | Sample of this invention |
|---|---|---|
| Mean value | 74.31ns | 75.95ns |
| Standard error | 1.92ns | 2.11ns |

4M DRAM was used in the test. With $t_{RAC}$ = 80 nsec, the range of the power source voltage allowing operation ($V_{cc}$ margin) was observed.

|  | Tape-attached LOC (conventional sample) | Sample of this invention |
|---|---|---|
| Mean value | 3.86V | 3.91V |
| Standard error | 0.07V | 0.10V |

As explained above, there is little difference between the conventional sample and the sample of this invention. Consequently, it is clear that there is no problem for the samples of this invention with respect to the electrical degradation.

Cost performance:

For manufacturing of 4M DRAM on 6-in wafer, the manufacturing cost of materials for 1 unit according to this invention is about 1/33 that for the conventional scheme.

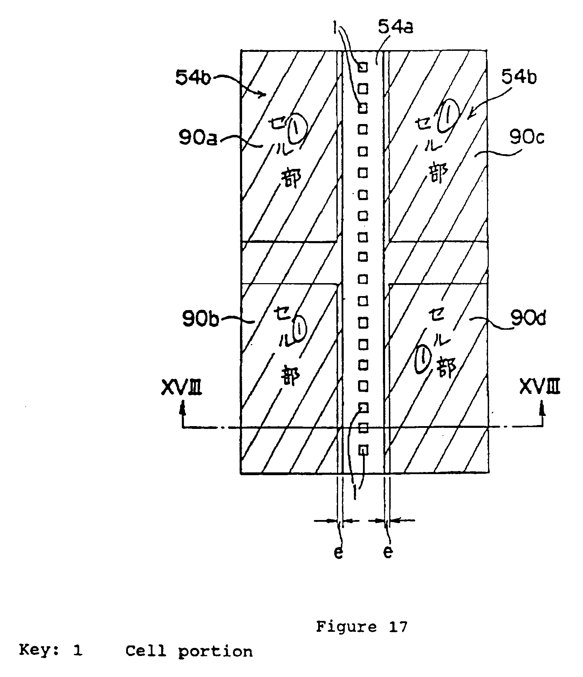

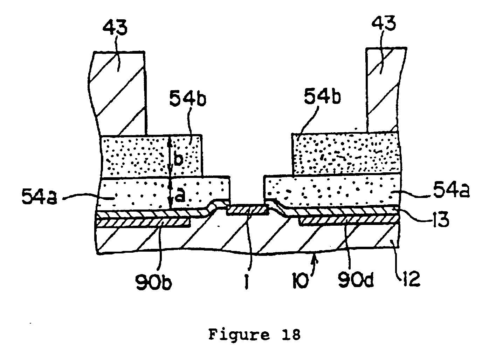

Figs. 17-26 are diagrams illustrating Embodiment 2 with certain features different from that of Embodiment 1.

According to Embodiment 2, as illustrated schematically in Fig. 17, thermoplastic polyimide-type resin layer 54b is arranged on the region represented by the hatched portion in the figure, that is, almost over the entire region of the IC's memory cells 90a, 90b, 90c, 90d.

Consequently, instead of arranging thermoplastic polyimide-type resin layer 54b on the mount region (bonding region) of lead frame 11 as adopted in the above Embodiment 1, in this case, it is also arranged on heat-settable polyimide-type resin layer 54a of the nonbonding region of lead frame 11.

The thicknesses of the various polyimide resin layers and other parameters are selected preferably as follows:

Thickness of resin layer 54b (b) = 15-35 μm

Thickness of resin layer 54a (a) = 10-30 μm

Gap between the end of the cell portion and the end of resin layer 54b e = 100-500 μm

a + b = 35-65 μm

For the overall package, the dimensions of the various portions (see Fig. 1) are selected as listed in Table III.

EP 0 665 592 A1

Table III

| | | 1mm T S O P | | 2.7mm S O J | |
|---|---|---|---|---|---|
| | A | 0.195mm | (195μm) | 0.810mm | (810μm) |
| | B | 0.125mm | (125μm) | 0.200mm | (200μm) |
| | b | 0.020mm | (20μm) | 0.020mm | (20μm) |
| | a | 0.015mm | (15μm) | 0.015mm | (15μm) |
| | E | 0.280mm | (280μm) | 0.280mm | (280μm) |
| | F | 0.370mm | (370μm) | 1.380mm | (1380μm) |
| | H | 0.355mm | (355μm) | 1.045mm | (1045μm) |
| | I | 0.370mm | (370μm) | 1.380mm | (1380μm) |
| | J | 15.240mm | (15240μm) | 15.240mm | (15240μm) |

For the package in this embodiment, lead frame 11 can be directly mount-pressed and bonded on the polyimide resin layer as protective film, in particular, on thermoplastic polyimide-type resin layer 54b. Consequently, it is possible to realize effects (1)-(4) explained in said Embodiment 1. In addition, since resin layer 54b is arranged almost on the entire surface of the cell portion, said gap e is maintained. Consequently, the warpage of the IC chip can be further reduced. Also, the tensile stress on the surface of the chip right below the corner portion of the bus bars is 3.31 kg/mm$^2$, about 20% lower than that in the conventional scheme.

In this embodiment, as thermoplastic polyimide-type resin layer 54b is arranged almost on the entire region of the cell portion, the structure is highly effective in preventing the soft error caused by α particles.

That is, since the cell portion is covered with a laminate film of thermoplastic polyimide-type resin layer 54b with thickness of 15-35 μm and heat-settable polyimide-type resin layer 54a with thickness of 10-30 μm, the thickness of the protective film made of these two resin layers is 35-65 μm. Here, Flight distance of α particles in polyimide is about 30 μm. For the polyimide resin layer on the memory cell portion, the thickness (total thickness: a + b) is at least 35 μm in the structure of this invention. The α particles emitted from the filler (SiO, etc.) in molding resin 18 or in the lead frame can be shielded effectively, and it is thus possible to prevent soft error of the memory cell portion.

When the thickness of the polyimide resin layer is small, [in the conventional method], it is necessary to take measures to reduce the α particles, such as reducing the content of uranium or thorium in SiO$_2$ (silica) using the sol-gel method. However, this raises the cost. On the other hand, in this embodiment of this invention, the α particles can be shielded effectively as explained in the above. Consequently, there is no need to perform specific measure to reduce the α particles, and the cost of the molding resin can be cut by about half as indicated in the following table.

| Presence/absence of measures for reducing α particles | Content of uranium and thorium in the filler | Ratio of price of the molding resin |
|---|---|---|
| Sealing resin treated for reducing the α particles from the filler | 1 ppb | 2.0 |
| Sealing resin without taking measure for reducing the α particles from the filler (this embodiment) | 100ppb | 1.0 |

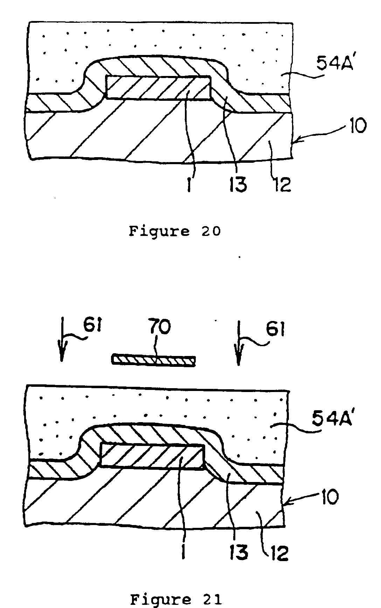

The principal process of the manufacturing method of the package in this embodiment is explained in the following. First of all, as shown in Fig. 20, a 15-μm-thick layer of heat-settable polyimide-type resin 54A' was coated on a passivation film 13 with semiconductor circuitry formed on it. Prebaking was then performed (100°C x 360 sec).

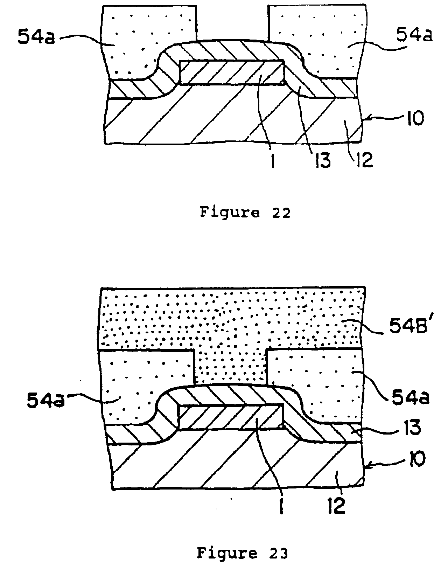

Next, as shown in Fig. 21, overall exposure was performed using UV light 61 with the aid of an exposure mask 70 for 70 sec. As shown in Fig. 22, the bonding pad portion 1 and the scribe lines (not shown in the figure) were then formed by etching, followed by heat setting of the polyimide resin at 390°C for 60 min, forming resin layer 54a.

As shown in Fig. 23, after polyimide resin 54B' was coated, prebaking was performed at 125°C for 2 min on a hot plate.

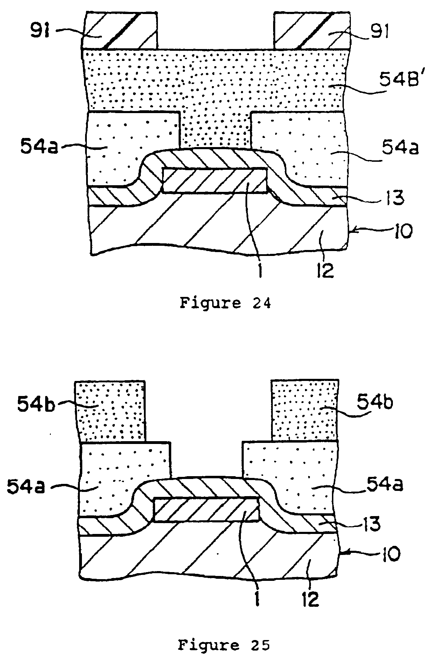

As shown in Fig. 24, after coating of resist 91, a UV exposure equipment was used to perform exposure for 250 mJ/cm as shown in Fig. 25, followed by development treatment (etching) of the scribe line and bonding pad portions, forming resin layer 54b.

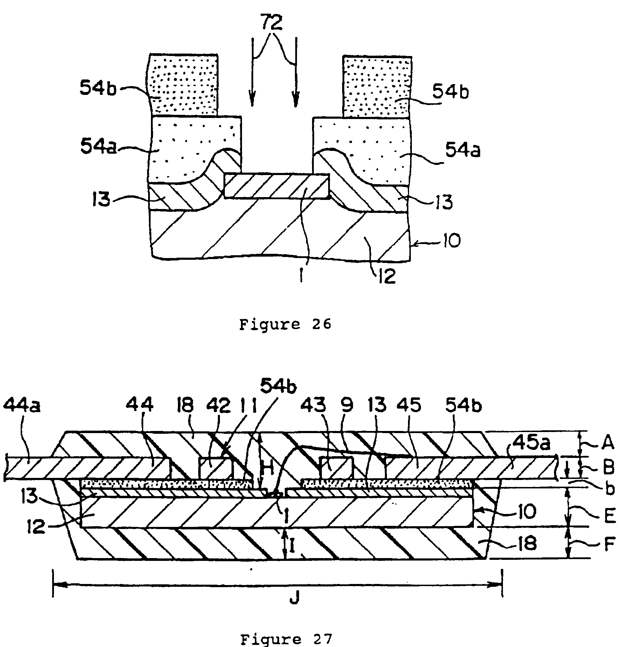

After peeling of the resist, final curing was performed (250°C x 60 min). As shown in Fig. 26, by means of $CF_4 + O_2$ plasma 72, the passivation film on pad 1 was removed.

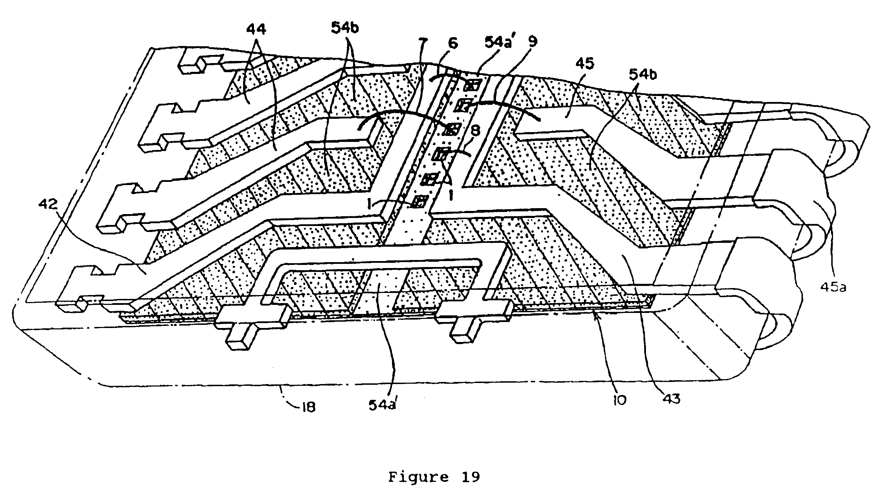

In addition, as shown in Fig. 19, after the inner lead (made of 42-alloy) was hot-pressed at 350°C x 4 kg, wire bonding was performed by means of wire (made of 99.99% gold), followed by injection molding of the heat-settable molding resin, then heat setting (curing) at 175°C for 5 h. The package obtained is of the SOJ 34-pin type measuring 600 mil (width) x 875 mil (length) x 106 mil (height).

Figs. 27-37 are diagrams illustrating Embodiment 3, with certain features different from that of Embodiment 1.

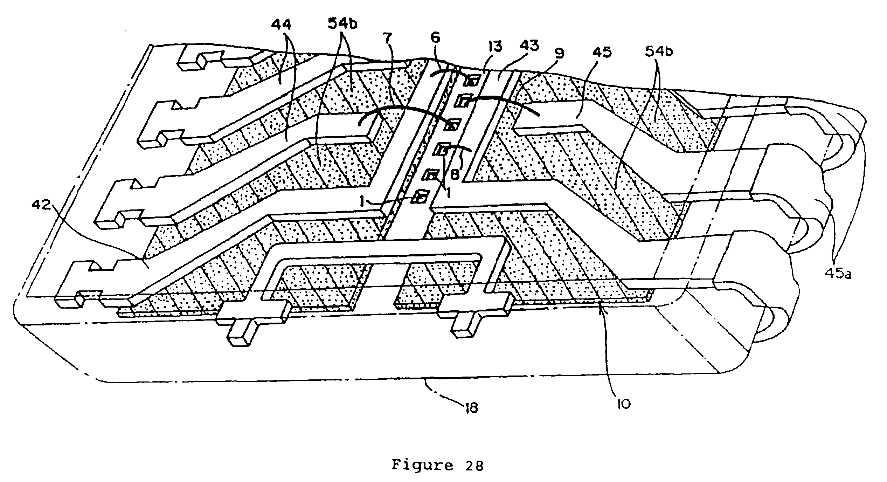

According to Embodiment 3, as illustrated in Figs. 27 and 28, the second protective film is formed from thermoplastic polyimide-type resin layer 54b alone. This resin layer 54b is arranged on the region represented by the hatched portion in Fig. 17, that is, almost over the entire region of the IC's memory cells 90a, 90b, 90c, 90d (the other structural features are identical to those in the aforementioned embodiments).

The thickness of the polyimide-type resin layer 54b and other parameters are selected preferably as follows, and the material (molding resin 18) may be the same as that used in said Embodiment 1 (the material may have a glass transition point at 210°C and a dielectric constant of 3.3).

Thickness of resin layer 54b (b) = 30-50 μm

Gap between the end of the cell portion and the end of resin layer 54b e = 100-500 μm

The reasons for setting the glass transition point of thermoplastic polyimide-type resin layer 54b at 210°C are as follows. The temperature is lower than 400°C when the lead frame is heat pressed and bonded on the surface of the IC chip, and the wire bonding temperature is set at 200°C. At temperatures in the range of glass transition point + (100-150°C), the lead frame can be hot pressed and bonded on the surface of the IC chip. When the lead frame is hot pressed and bonded at a temperature higher than 400°C, it is [impossible] to suppress oxidation of the lead frame, thermal impact on the IC chip element and thermal stress. The wire bonding temperature at 200°C is a temperature that enables bonding in mass production. When the glass transition point is not set at 200°C or higher, the effect of viscosity of the thermoplastic polyimide-type resin is displayed in the case of lead frame bonding.

For the overall package, the dimensions of the various portions are selected as listed in Table IV.

Table IV

|  | 1mm T S O P | | 2.7mm S O J | |
|---|---|---|---|---|
| A | 0.195mm | (195μm) | 0.810mm | (810μm) |
| B | 0.125mm | (125μm) | 0.200mm | (200μm) |
| b | 0.030mm | (30μm) | 0.030mm | (30μm) |
| E | 0.280mm | (280μm) | 0.280mm | (280μm) |
| F | 0.370mm | (370μm) | 1.380mm | (1380μm) |
| H | 0.350mm | (350μm) | 1.040mm | (1040μm) |
| I | 0.370mm | (370μm) | 1.380mm | (1380μm) |
| J | 15.240mm | (15240μm) | 15.240mm | (15240μm) |

For the package in this embodiment, lead frame 11 can be directly mount-pressed and bonded to polyimide resin layer 54b as protective film. Consequently, it is possible to realize effects (1)-(4) explained in said Embodiment 1. In addition, as resin layer 54b on the periphery of the bonding pad is removed by means of etching in a linear profile, while said gap e is maintained (see Fig. 17), it is possible to suppress the IC chip package to smaller than 100 μm. Also, the tensile stress on the surface of the chip right below the corner portion of the bus bars is 2.90 kg/mm$^2$, about 30% lower than that in the conventional scheme.

In this embodiment, as almost all of the cell portion is covered with a laminate film made of thermoplastic polyimide-type resin layer 54b with a thickness over 30 $\mu$m, the cell portion can be shielded from $\alpha$ particles. For the configuration of this embodiment, $\alpha$ particles emitted from the filler (SiO$_2$, etc.) in molding resin 18 or lead frame can be shielded effectively, and it is thus possible to prevent soft error of the memory cell portion.

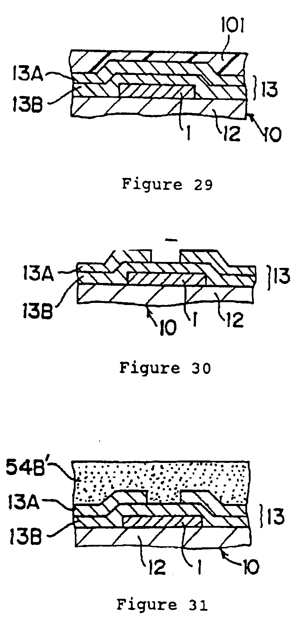

The principal process of the manufacturing method of the package in this embodiment is explained in the following. First of all, as shown in Fig. 29, a resist layer 101 was coated on passivation film 13 with semiconductor circuitry formed on it. UV irradiation was then performed selectively with the aid of an exposure mask (not shown in the figure), and the unexposed portion (on the bonding pad) was removed.

As shown in Fig. 30, after selective removal of Si$_3$N$_4$ layer 13A with the aid of the resist used as a mask, a thermoplastic polyimide-type resin layer 54B' was coated as shown in Fig. 31, followed by prebaking at 125°C for 2 min on a hot plate.

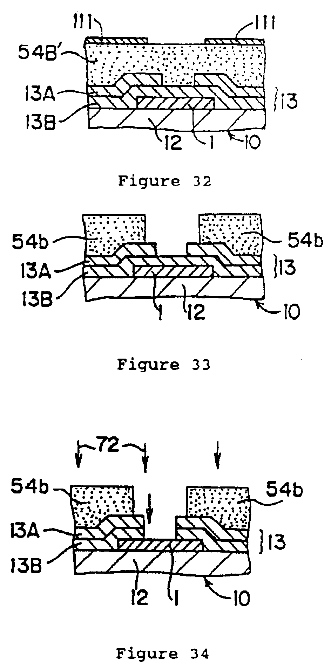

As shown in Fig. 32, resist layer 111 was applied. As shown in Fig. 33, a UV stepper was used for exposure at 250 mJ/cm, followed by development treatment (etching) for the scribe lines and the bonding pad portion, forming resin layer 54b.

After peeling of the resist, final curing was performed (250°C x 60 min). As shown in Fig. 34, by means of CF$_4$ + O$_2$ plasma 72, the passivation film on pad 1 was removed.

In addition, as shown in Fig. 27, after the inner lead (made of 42-alloy) was hot-pressed at 350°C x 4 kg, wire bonding was performed (with wire made of 99.99% gold), followed by the injection molding of a heat-settable molding resin, then heat setting (curing) at 175°C for 5 h. The obtained package is of the SOJ 34-pin type, measuring 600 mil (width) x 875 mil (length) x 106 mil (height).

For the package formed in the above in this embodiment, the following evaluations were performed.

IR reflow test:

The results of the IR reflow test (Max 245°C) after setting at 85°C/85% RH for 336 h are as follows. No package cracks developed. This is because the moisture absorption of the thermoplastic polyimide-type resin was selected as lower than 1.0%.

|  | This embodiment | Conventional scheme |
|---|---|---|
| Defective rate | 0/120 | 16/120 |

Temperature cycle test (-65°C to 150°C):

The results of the test of temperature cycles are as follows. No package cracks developed.

|  | This embodiment | Conventional scheme |
|---|---|---|
| Defective rate after 2000 cycles | 0/20 | 0/20 |

Soft errors:

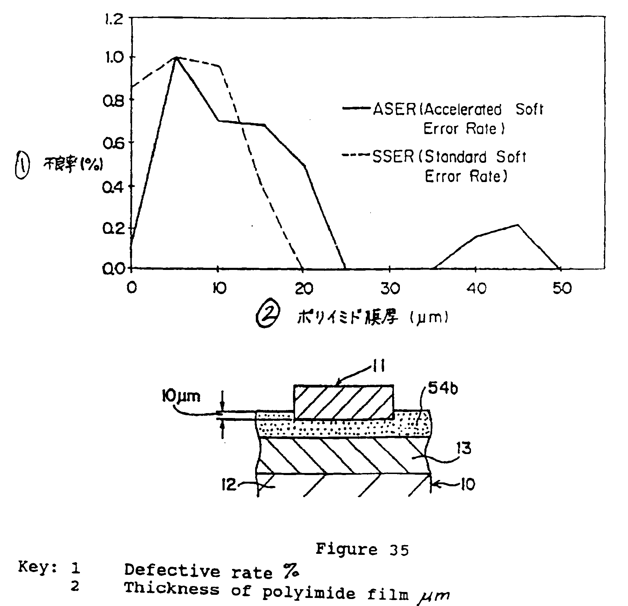

As shown in Fig. 35, since the thickness of thermoplastic polyimide-type resin layer 54b was 30-50 $\mu$m, the ASER (Accelerated Soft Error Rate) and other soft errors caused by $\alpha$ particles can be significantly reduced for 4M DRAM. On the other hand, when the thickness of the resin layer is smaller than 20 $\mu$m, the rate of the soft errors is increased.

In this case, as shown in Fig. 35, when lead frame 11 is hot pressed and bonded on the surface of resin layer 54b on the surface of the IC chip, lead frame 11 sinks into resin layer 54b at a depth of about 10 $\mu$m. Consequently, when the thickness of thermoplastic polyimide-type resin layer 54b is not set at 30 $\mu$m or larger, ASER problems may easily occur.

As explained in the above, in order to prevent high ASER (Accelerated Soft Error Rate), a coating layer with a thickness of 20 $\mu$m or larger (30 $\mu$m or larger before mounting) should be formed on the cell portion of the IC chip. In the conventional structure (Fig. 41), only a coating layer (polyimide resin layer) 14 with a thickness of 10 $\mu$m is coated on the cell portion of the chip. Consequently, as a measure for preventing ASER, a treatment should be performed to reduce the content of uranium and thorium in the molding sealant to less than 1 ppb (the content of uranium and thorium in the conventional molding sealant is about 100 ppb). Consequently, the price of the molding sealant is twice the conventional price. On the other hand, in this embodiment, thermoplastic polyimide-type resin layer 54b with a thickness of 30 μm is coated on the cell portion. Consequently, there is no need to be concerned about a poor ASER, and it is possible to make use of the conventional sealant (with a uranium and thorium content of 100 ppb), and the price can thus be halved.

Parasitic capacitance:

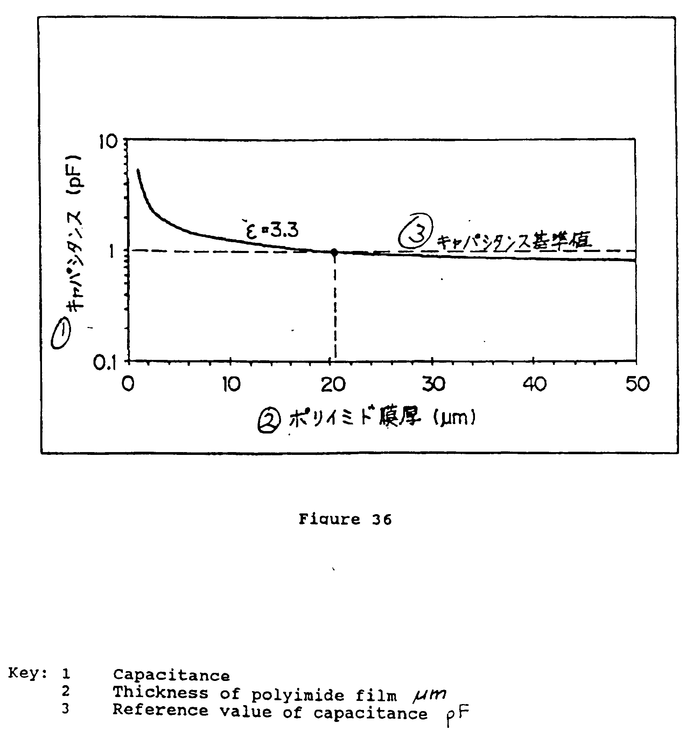

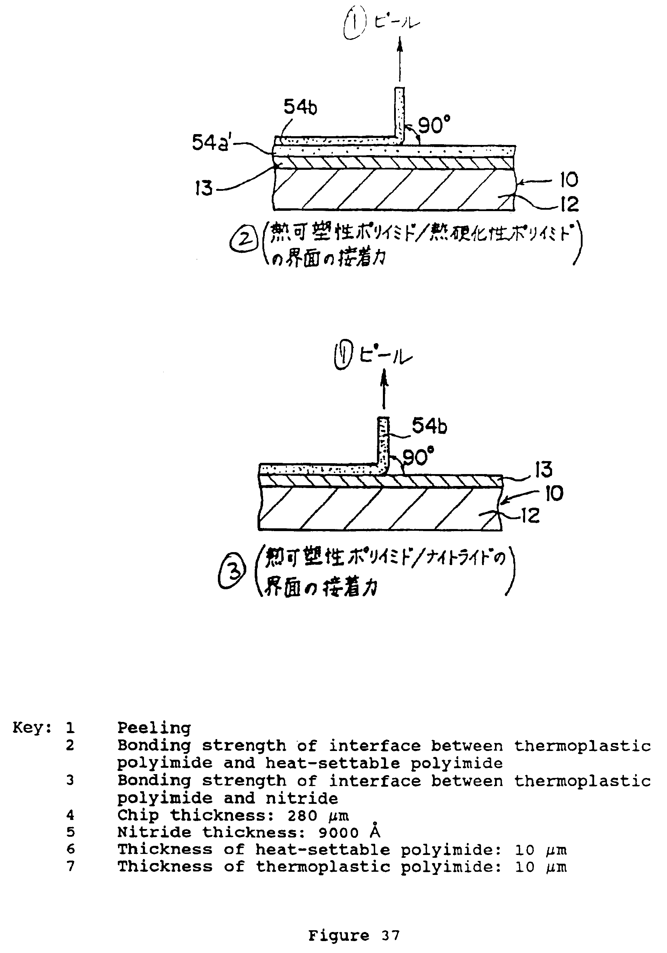

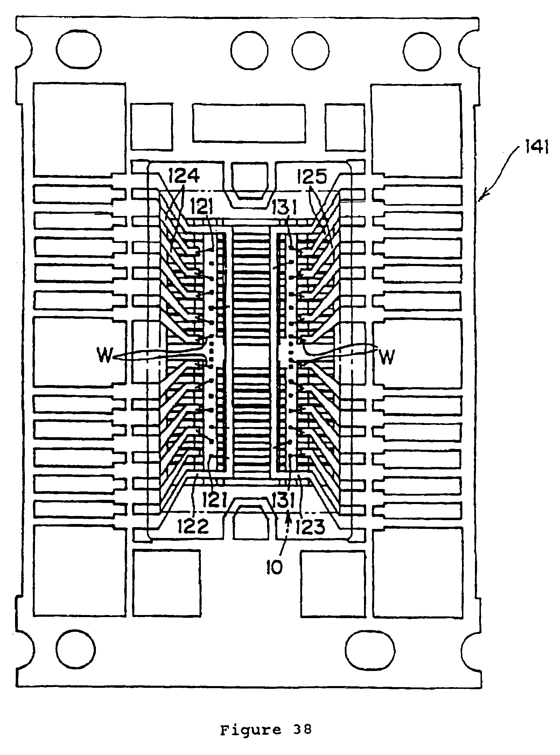

When the aforementioned lead frame is used in the bit line of DRAM, in order to suppress the parasitic capacitance (bit-line to lead frame capacitance) to lower than 1 pf, as shown in Fig. 36, it is necessary to have the thickness of the thermoplastic polyimide-type resin layer 54b larger than 30 μm. After pressing and bonding of the lead frame, the thickness should be larger than 20 μm.

The curve shown in Fig. 36 was derived using the following formula.

$$C = 4\pi\varepsilon_0\varepsilon/1n\,(4t^2) \quad (2)$$

where,

t: thickness of polyimide resin layer

$\varepsilon$: dielectric constant of polyimide resin (3.3)

$\varepsilon_0$: vacuum dielectric constant

C: capacitance

Mass production and cost performance:

When the thickness of the thermoplastic polyimide-type resin layer 54b is larger than 50 μm (or larger than 80 μm before curing), it takes about 5 min or longer to etch it. This is inappropriate for mass production. In this embodiment, since the aforementioned thickness is reduced to 50 μm or smaller, the etching time can be shortened. Also, for the package in this embodiment, no double-sided adhesive tape (insulating tape) is used. Consequently, the lead frame can be mount-pressed and bonded directly. As a result, the mounting processability of the lead frame is improved, and the price of the lead frame can be significantly reduced to about 1/7-1/10 of the present level.

Bonding strength:

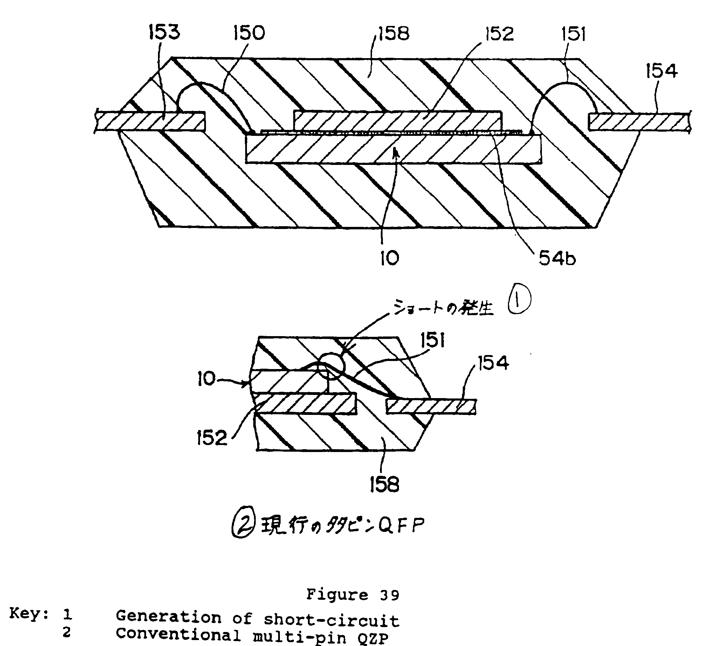

As shown in Fig. 37, the measurement was performed based on the 90° peeling test method defined in ISO standard 4578-1979 to derive the bonding strength at the interface between thermoplastic polyimide-type resin layer 54b and heat-settable polyimide-type resin layer 54a', as well as the interface between thermoplastic polyimide-type resin layer 54b and nitride (passivation film 13). According to ISO standard, the samples used in the 90° peeling test have a width of 2.5 ± 0.05 cm. The results are listed in the following Table V.

Table V

| Sample No. | Thermoplastic polyimide-type resin | | | Bonding Strength (g/cm) | |
|---|---|---|---|---|---|
| | Glass transition point | Pyrolysis temperature | Moisture absorption | Bonding strength between thermoplastic polyimide-type resin and heat-settable polyimide-type resin | Bonding strength between thermoplastic polyimide-type resin and nitride |
| 1 | 245 | 430 | 0.4 | 152 | 671 |
| 2 | 226 | 400 | 0.3 | 176 | 632 |
| 3 | 218 | 380 | 0.3 | 143 | 655 |
| 4 | 282 | 520 | 2.2 | 232 | 1012 |
| 5 | 228 | 440 | 1.8 | 481 | 1311 |
| 6 | 228 | 440 | 1.8 | 467 | 1431 |
| 7 | 228 | 440 | 1.8 | 432 | 1460 |
| 8 | 260 | 480 | 2.2 | 145 | 903 |
| 9 | 240 | 450 | 1.5 | 273 | 892 |
| 10 | 180 | 350 | 1.6 | 262 | 1326 |
| 11 | 268 | 410 | 0.9 | 125 | 517 |
| 12 | 278 | 420 | 2.0 | 176 | 420 |
| 13 | 272 | 370 | 1.7 | 328 | 691 |

For 13 types of samples, a measurement of the bonding strength was performed. The results indicate that the bonding strength between the thermoplastic polyimide-type resin and the heat-settable polyimide-type resin is lower than that between the thermoplastic polyimide-type resin and nitride. That is, the reliability of the one-layered structure in this embodiment (polyimide resin) is higher than that of the two-layered structure (thermoplastic polyimide-type resin/heat-settable polyimide-type resin).

From the results of the aforementioned measurement, the bonding strengths are in the following ranges:

Bonding strength between thermoplastic polyimide-type resin and heat-settable polyimide-type resin: 100-500 g/cm

Bonding strength between thermoplastic polyimide-type resin and nitride: 400-1500 g/cm

The bonding strength is determined from the results when the thickness of the samples for the peeling test is 10 μm. When the thickness of the samples in the peeling test (in particular, the polyimide resin) is changed, the bonding strength estimated on the basis of an elastic mechanical analysis are as follows.

$$P (1 - \cos \theta) + (P^2 /2C_s E) = W_a \quad (3)$$

where,

P: bonding strength (g/cm)

$\theta$: peeling angle (°)

E: modulus of sample for peeling (dyn/cm$^2$)

$W_a$: bonding work (erg/cm$^2$)

$C_s$: thickness of thermoplastic polyimide-type resin layer (cm)

Here, with $\theta = 90°$, one has

$$P + (P^2 /2C_s E) = W_a \quad (4)$$

From the above formula, the possible ranges for the bonding strength can be summarized in the following

15

Table VI.

Table VI

| Thickness of thermoplastic polyimide-type resin layer | Bonding strength between thermoplastic polyimide-type resin and heat-settable polyimide-type resin | Bonding strength between thermoplastic polyimide-type resin and nitride | |
|---|---|---|---|
| 10μm | 100~500g/cm | 400~1500g/cm | Measured value |
| 20μm | 71~354g/cm | 283~990g/cm | Calculated value |
| 30μm | 58~289g/cm | 231~808g/cm | |
| 40μm | 50~250g/cm | 200~700g/cm | |
| 50μm | 45~224g/cm | 179~626g/cm | |

Fig. 38 is a diagram illustrating Embodiment 4 of this invention, with a LOC configuration as a feature different from the aforementioned embodiments.

In this embodiment, on IC chip 10 indicated by broken lines, bonding pads 121 and 131 are arranged in a column on both the left and right sides. Signal lines 124, 125 and bus bars 122, 123 are arranged on the two sides of each column of pads, respectively. Also, for each pad column, a connection is made by bonding wire W to signal lines on one side, and to the bus bars on the other side (the other features of the structure are basically identical to those in the aforementioned embodiments).

Consequently, unlike the aforementioned embodiments, the wires do not stride over the bus bars. Short-circuit between the signal line and bus bar can be even more reliably prevented for lead frame 141. Consequently, there is no need to increase the height of wire W, which is favorable for reduction of the thickness of the resin-molded package.

Fig. 39 is a diagram illustrating Embodiment 5 of this invention for application on other types of packages.

In this embodiment, for a multi-pin QFP (Quad Flat Package), IC chip mount portion 152 of a lead frame with a LOC structure was hot pressed and bonded on IC chip 10 via thermoplastic polyimide-type resin layer 54b; bonding pad 161 on the periphery of IC chip 10 is wire-bonded on inner lead portions 153, 154 by means of wires 150, 151, and the overall assembly is sealed by means of molding resin 158. The film structure beneath resin layer 54b may be designed in the same manner as in the aforementioned embodiment.

For the package in this embodiment, no insulating tape attached with adhesive on two sides is used. Consequently, by means of thermoplastic polyimide-type resin layer 54b, the lead frame is mount-pressed and bonded on the IC chip. Consequently, the same effect as that in the aforementioned embodiments can be realized.

In addition, wire bonding is performed between the peripheral portion of the IC chip and the inner lead portion. Consequently, as shown in Fig. 39, it is possible to prevent constant short-circuit of the wire with respect to the chip, a problem that is prone to take place when IC chip 10 attached to mount portion 152 and the inner lead portion are wire-bonded to each other.

In the above, this invention has been explained with reference to embodiments. However, this invention is not limited to these embodiments, and other modifications are allowed as long as the basic technological ideas of this invention are observed.

For example, in said Embodiment 1, as shown in Fig. 3, there is a difference in the thickness for thermoplastic polyimide-type resin layer 54a between the lead frame mounting region and the other region, yet the same thickness (a) is selected almost over the entire region. In this case, the effect of preventing the soft errors caused by α particles can be improved. This effect can be maintained when thickness (c) of resin layer 54a is increased for the region outside the lead frame mounting region. Also, it is possible to increase the number of layers of the laminate, for example, it is possible to laminate a third resin layer in addition to the aforementioned two resin layers.

Also, thermoplastic polyimide-type resin layer 54b may be arranged over almost the entire region in the structure shown in Fig. 3. As far as the material is concerned polyimide resin was used. However, it is also possible to use other types of resins, such as polyester resins and polyether amidoimide resins (the same is true for the heat-settable resin). For the molding resin, in addition to the polyfunctional epoxy resin, it is also possible to use other types, such as orthocresol-novolac epoxy resins, biphenyl resins, napthphalene resins, etc. It is also possible to make various changes of the materials to making form the various other portions of the package.

Also, this invention can be applied for various types of packages, such as the TSOP type, SOJ type, etc. This invention is also not limited to DRAM (16 M, 64 M, etc.), it can also be used for various other types of devices.

As explained in the above, according to this invention, the principal portion of the lead frame is bonded through the thermoplastic resin layer, which at the least acts as a portion of the second protective film. Consequently, it is possible to reduce the thickness of the adhesive layer for mounting the lead frame. As a result, it is possible to prevent breakage of the metal wiring after mount-pressing bonding and during the various temperature cycles; it is also possible to reduce the package cracks that are prone to take place during IR reflow, to ensure the package balance (reducing the package warpage), and to cut the cost.

## Claims

1.  A semiconductor device comprising a first protective film on a semiconductor chip, a second protective film arranged on the first protective film, and a plurality of leads from a lead frame electrically connected to a circuit formed in the semiconductor chip, a main portion of the lead frame being attached to the second protective film.

2.  The semiconductor device of claim 1, wherein the lead frame is attached by a resin which acts as at least a portion of the second protective film.

3.  The semiconductor device of claim 1, wherein the resin is a thermoplastic resin.

4.  The semiconductor device of any preceding claim, wherein the second protective film is a laminate, with its lower layer made of a heat-settable polyimide-type resin and its upper layer made of a thermoplastic polyimide-type resin.

5.  The semiconductor device of claim 4, wherein in the region where the lead frame is bonded, the thermoplastic polyimide-type resin layer and the heat-settable polyimide-type resin layer are formed with almost the same pattern; with the thickness of the aforementioned thermoplastic polyimide-type resin layer being 15-35 $\mu$m, and the thickness of the heat-settable polyimide-type resin being 10-30 $\mu$m, and wherein also in the nonbonding region of the lead frame the thickness of the heat-settable polyimide-type resin is 5-15 $\mu$m.

6.  The semiconductor device of claim 4 or claim 5, wherein the thermoplastic polyimide-type resin layer is also arranged on the heat-settable polyimide-type resin layer in the nonbonding region of the lead frame, the thickness of the thermoplastic polyimide-type resin layer being 15-35 $\mu$m, and the thickness of the heat-settable polyimide-type resin being 10-30 $\mu$m.

7.  The semiconductor device of any of claims 3 to 6, wherein the total thickness of the laminate is 35-65 $\mu$m at least in the bonding region of the lead frame.

8.  The semiconductor device of any preceding claim, wherein the second protective film is a thermoplastic polyimide-type resin.

9.  The semiconductor device of claim 8, wherein the thickness of the thermoplastic polyimide-type resin layer is 30-50 $\mu$m.

10. The semiconductor device of claim 8 or claim 9, wherein the thermoplastic polyimide-type resin is also arranged on a nonbonding region of the lead frame.

11. The semiconductor device of any preceding claim, wherein an end portion of the thermoplastic polyimide-type resin layer on the bonding region of the lead frame protrudes out from an end portion of the aforementioned lead frame by 0.1-0.15mm.

12. The semiconductor device of any preceding claim, wherein on the side of the bonding pad of the semiconductor chip, the gap between an end of a cell portion of the semiconductor chip and an end of the thermoplastic polyimide-type resin layer is 100-500 μm.

13. The semiconductor device of any preceding claim, wherein in a bonding pad region, there is a thermoplastic polyimide-type resin layer and/or a heat-settable polyimide-type resin layer.

14. The semiconductor device of any preceding claim, wherein a bonding pad and the lead frame are wire-bonded, with an overall body of the device being sealed off by resin.

15. The semiconductor device of any preceding claim, wherein the lead frame consists of a first lead frame portion for signal wiring and a second lead fame portion for power-source wiring.

16. A method of making the semiconductor device comprising the steps of coating a thermoplastic resin layer on the protective film of the semiconductor chip, then patterning and curing the coated resin, and then bonding the lead frame on the thermoplastic resin layer.

17. The method of claim 16, wherein after bonding of the lead frame, a step of wire-bonding a bonding pad of the semiconductor chip to the lead frame is performed.

Figure 1

Figure 2

Figure 3

Figure 4

Figure 5

Figure 6

Figure 7

Figure 8

Figure 9

54a

13

10

1

12

Figure 10

54A'

54a

54a

13

10

1

12

Figure 11

Figure 12

Figure 13

Figure 14

Figure 15

Figure 16

Figure 17

Key: 1    Cell portion

Figure 18

Figure 19

Figure 20

Figure 21

54a

54a

10

1  13  12

Figure 22

54B'

54a

54a

13

10

1  12

Figure 23

Figure 24

Figure 25

Figure 26

Figure 27

Figure 28

Figure 29

Figure 30

Figure 31

Figure 32

Figure 33

Figure 34

EP 0 665 592 A1

Figure 35

Key: 1    Defective rate %
      2    Thickness of polyimide film μm

39

Figure 36

Key: 1     Capacitance
     2     Thickness of polyimide film $\mu m$
     3     Reference value of capacitance $\rho F$

① ピール

54b

54a'

13

90°

10

12

② (熱可塑性ポリイミド／熱硬化性ポリイミド) の界面の接着力

① ピール

54b

90°

13

10

12

③ (熱可塑性ポリイミド／ナイトライドの) 界面の接着力

Key:  1     Peeling
      2     Bonding strength of interface between thermoplastic
            polyimide and heat-settable polyimide
      3     Bonding strength of interface between thermoplastic
            polyimide and nitride
      4     Chip thickness: 280 $\mu$m
      5     Nitride thickness: 9000 Å
      6     Thickness of heat-settable polyimide: 10 $\mu$m
      7     Thickness of thermoplastic polyimide: 10 $\mu$m

Figure 37

Figure 38

EP 0 665 592 A1

ショートの発生 ①

② 現行の多ピンQFP

Figure 39

Key: 1    Generation of short-circuit
     2    Conventional multi-pin QZP

43

Figure 40

EP 0 665 592 A1

Figure 41

Figure 42

EP 0 665 592 A1

Figure 43

Figure 44

Figure 45

46

Figure 46

Figure 47

Key: 1    IR test after absorption of moisture

Figure 48

**European Patent Office**

# EUROPEAN SEARCH REPORT

Application Number

EP 95 30 0600

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| P,X | PROCEEDINGS OF THE 44TH ELECTRONIC COMPONENTS & TECHNOLOGY CONFERENCE, 1 May 1994 WASHINGTON, D.C., pages 506-512, XP 000479177 MASAZUMI AMAGAI ET AL.: 'development of a tapeless lead-on-chip (loc) package' * the whole document * | 1-17 | H01L23/495 |
| P,X | US-A-5 286 679 (FARNWORTH WARREN M ET AL) 15 February 1994 * the whole document * | 1-3, 7-10, 14-17 | |
| X | WO-A-93 04498 (STAKTEK CORP) 4 March 1993 | 1-5,7-9, 14,16,17 | |
| Y | * page 5, line 8 - line 24 * * page 7, line 12 - page 8, line 13 * * page 12, line 6 - page 13, line 6 * * page 14, line 7 - line 22 * * page 26, line 25 - page 27, line 18; claims 6-8 * | 11,15 | |
| Y | EP-A-0 504 821 (HITACHI LTD ;TEXAS INSTRUMENTS INC (US)) 23 September 1992 * column 9, line 31 - column 11, line 41; figures 8-11 * | 11,15 | |

**TECHNICAL FIELDS SEARCHED** (Int.Cl.6)

H01L

The present search report has been drawn up for all claims

| Place of search | Date of completion of the search | Examiner |
|---|---|---|
| THE HAGUE | 10 May 1995 | Zeisler, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)